## Europäisches Patentamt

(19) **European Patent Office**

**Office européen des brevets**

(11) Veröffentlichungsnummer: **0 112 480**
**B1**

(12) # EUROPÄISCHE PATENTSCHRIFT

(45) Veröffentlichungstag der Patentschrift:
26.10.88

(51) Int. Cl.⁴: **H 01 L 31/02**

(21) Anmeldenummer: 83111371.7

(22) Anmeldetag: 14.11.83

(54) **Solarzelle aus amorphem Silizium.**

(30) Priorität: **19.11.82 DE 3242835**

(43) Veröffentlichungstag der Anmeldung:
**04.07.84 Patentblatt 84/27**

(45) Bekanntmachung des Hinweises auf die Patenterteilung:
**26.10.88 Patentblatt 88/43**

(84) Benannte Vertragsstaaten:
**DE FR GB IT**

(56) Entgegenhaltungen:
**EP - A - 0 002 433**
**US - A - 4 320 251**

**THE CONFERENCE RECORD OF THE FOURTEENTH IEEE PHOTOVOLTAIC SPECIALISTS CONFERENCE, 7.-10. Januar 1980, San Diego, California, Seiten 1406-1407, IEEE, New York, US; B. ROSS: "The use of eutectic alloys in screened contacts"**
**APPLIED PHYSICS LETTERS, Band 39, Nr. 3, August 1981, Seiten 256-258, American Institute of Physics, New York, US; P.H. FANG u.a.: "Submicron polycrystal silicon film solar cells"**
**PATENTS ABSTRACTS OF JAPAN, Band 5, Nr. 11 (E-42)[683], 23. Januar 1981**

**Die Akte enthält technische Angaben, die nach dem Eingang der Anmeldung eingereicht wurden und die nicht in dieser Patentschrift enthalten sind.**

(73) Patentinhaber: **Siemens Aktiengesellschaft Berlin und München, Wittelsbacherplatz 2, D-8000 München 2 (DE)**

(72) Erfinder: **Kausche, Helmold, Dipl.-Phys., Tessinerstrasse 146, D-8000 München 71 (DE)**
Erfinder: **Möller, Matthias, Dipl.-Phys., Plievierpark 12, D-8000 München 83 (DE)**
Erfinder: **Fischer, Franz, Dr., Gersteckerstrasse 32, D-8000 München 82 (DE)**

## Beschreibung

Die Patentanmeldung betrifft eine Solarzelle mit einem, aus amorphem Silizium bestehenden Halbleiterkörper, der auf einem zumindest an seiner Oberfläche mit einer als Rückkontakt dienenden Metallschicht versehenen Substrat aufgebracht ist.

Der Aufbau von Solarzellen aus amorphem Silizium (= a-Si) auf isolierenden, nicht notwendig transparenten Trägern wie Glas, Keramik oder Kaptonfolie (= Polyimidfolie) ist von besonderer Bedeutung, da hier serienverschaltete Solarzellen auf einem Träger durch einfache Maskentechnik hergestellt werden können. Als Rückkontakt muss dazu zunächst eine Metallschicht mit niedrigem Flächenwiderstand (ca. 50 mOhm bei 50 cm$^2$ Zellengrösse) auf den Träger aufgebracht werden.

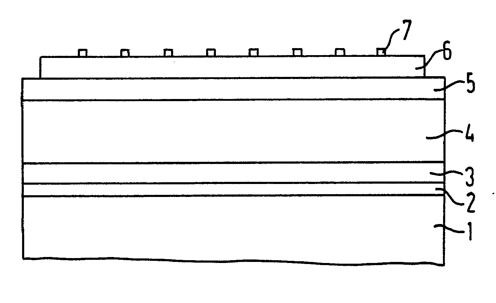

Aus dem Tagungsband der 15$^{th}$ IEEE Fotovoltaic Specialists Conference, Florida (1981) Seiten 922 bis 927 (Figur 1) ist es bekannt, als Substratmaterial Edelstahlscheiben zu verwenden.

Aus DE-A-3023165 ist Aluminium als Kontaktschicht für Siliziumsolarzellen bekannt. Aluminium-Silizium-Legierungen für diesen Zweck sind aus US-A-4320251 bekannt.

Wegen seiner hohen Leitfähigkeit und Preiswürdigkeit ist Aluminium als Rückkontakt besonders gut geeignet. Entscheidend ist bei der Herstellung durch Hochfrequenz-Zerstäuben, dass die Kristallitgrösse der Aluminiumschicht kleiner 50 nm ist, und dass die Schicht wegen der darauffolgenden a-Si:H-Abscheidung, die bei 250 °C erfolgt, thermisch stabil ist.

Aufgabe der Erfindung ist, eine amorphe Siliziumsolarzelle zu schaffen, die als Rückkontakt stabile, niederohmige Aluminiumschichten aufweist. Dabei muss die Kristallitgrösse möglichst klein gehalten werden.

Diese Aufgabe wird durch eine Solarzelle der eingangs genannten Art dadurch gelöst, dass die Metallschicht aus einer Aluminium/Silizium-Legierung mit oder ohne Titanzusatz besteht. Es liegt im Rahmen der Erfindung, dass der Siliziumanteil in der Legierung kleiner 2%, vorzugsweise 1,3% und bei Anwesenheit von 0,1% Titan 1,2% Silizium beträgt.

Die Herstellung dieser Schichten erfolgt durch Aufdampfen oder HF-Zerstäuben, wobei die Legierungsbestandteile bei der Abscheidung gleich in die Aluminiumschicht mit eingebaut werden.

Ein Zeichen, dass die Aluminium/Silizium- bzw. Aluminium/Silizium/Titan-Schichten nicht rekristallisieren, ist die Tatsache, dass auch bei weiteren Behandlungsschritten die Schichten blank bleiben und eine spiegelnde Oberfläche zeigen. Die erfindungsgemässe Schicht erfüllt diese Bedingungen sehr gut. Es wurden Flächenwiderstände um 50 m-Ohm mit Schichtdicken von 500 bis 1000 nm gemessen. Die Wirkungsgrade der so hergestellten Solarzellen (Fläche 50 cm$^2$) lag bei 5%.

Der Aufbau einer erfindungsgemässen Solarzelle (pin/ITO-Zelle) ist der in der Zeichnung befindlichen Figur zu entnehmen. Dabei ist mit dem Bezugzeichen

1 = Substratkörper, zum Beispiel aus Glas,
2 = Aluminium/Silizium- bzw. Aluminium/Silizium/Titan-Schicht (750 nm),
3 = amorphe Siliziumschicht (p-dotiert 20 nm)
4 = amorphe Siliziumschicht (Intrinsic 500 nm)
5 = amorphe Siliziumschicht (n-dotiert 10 nm)
6 = Indiumoxid-Zinnoxid-Schicht (Antireflexschicht 70 nm) und
7 = Fingerelektrodenstruktur
bezeichnet.

## Patentansprüche

1. Solarzelle mit einem aus amorphem Silizium bestehenden Halbleiterkörper, der auf einem zumindest an seiner Oberfläche mit einer als Rückkontakt dienenden Metallschicht versehenen Substrat aufgebracht ist, dadurch gekennzeichnet, dass die Metallschicht (2) aus einer Aluminium-Silizium-Legierung mit oder ohne Titanzusatz mit einem Siliziumanteil kleiner 2% besteht.

2. Solarzelle nach Anspruch 1, dadurch gekennzeichnet, dass der Siliziumanteil 1,3% beträgt.

3. Solarzelle nach Anspruch 1, dadurch gekennzeichnet, dass die Aluminium-Silizium-Legierung mit einem Anteil von mindestens 1% Silizium 0,1–0,2% Titan enthält.

4. Solarzelle nach einem der Ansprüche 1 bis 3, dadurch gekennzeichnet, dass die Schichtdicke der Aluminium/Silizium- bzw. Aluminium/Silizium/Titan-Schicht (2) 500 bis 1000 nm und der spezifische Widerstand 3 µOhm . cm beträgt.

## Claims

1. A solar cell comprising a semiconductor body which consists of amorphous silicon and which is applied to a substrate provided at least at its surface with a metal layer which serves as rear contact, characterised in that the metal layer (2) consists of an aluminium-silicon alloy with or without a titanium addition with a silicon portion of less than 2%.

2. A solar cell as claimed in Claim 1, characterised in that the silicon portion amounts to 1.3%.

3. A solar cell as claimed in Claim 1, characterised in that the aluminium-silicon alloy contains with a portion of at least 1% silicon, 0.1–0.2% titanium.

4. A solar cell as claimed in one of Claims 1 to 3, characterised in that the layer thickness of the aluminium/silicon or aluminium/silicon/titanium layer (2) amounts to 500 to 1000 nm and the specific resistance to 3 µOhm . cm.

## Revendications

1. Cellule solaire comprenant un corps semiconducteur en silicium amorphe, qui est déposé sur un substrat muni, au moins sur sa surface, d'une couche métallique servant de contact arrière, caractérisée en ce que la couche métallique (2) est en un alliage d'aluminium et de silicium avec ou sans addition de titane et ayant une proportion de silicium inférieure à 2%.

2. Cellule solaire suivant la revendication 1, caractérisée en ce que la proportion de silicium est de 1,3%.

3. Cellule solaire suivant la revendication 1, caractérisée en ce que l'alliage d'aluminium et de silicium ayant une proportion d'au moins 1% de silicium contient de 0,1 à 0,2% de titane.

4. Cellule solaire suivant l'une des revendications 1 à 3, caractérisée en ce que l'épaisseur de la couche d'aluminium et de silicium ou d'aluminium, de silicium et de titane est comprise entre 500 et 1000 nm et la résistivité est de 3 µOhm . cm.